# EUROPÄISCHE PATENTSCHRIFT

(11) **EP 1 973 158 B1**
(45) Veröffentlichungstag und Bekanntmachung des Hinweises auf die Patenterteilung: **16.03.2016**
(21) Anmeldenummer: 07006090.0
(22) Anmeldetag: 23.03.2007
(51) Int. Cl.: H01L 23/498, H01L 23/13

(54) **Elektronisches Bauteil**
Electronic component
Composant électronique

(43) Veröffentlichungstag der Anmeldung: 24.09.2008
(73) Patentinhaber: Delphi International Operations Luxembourg S.à r.l., 4940 Bascharage (LU)
(72) Erfinder: Wirths, Jochen, 51545 Waldbroel (DE); Kortwig, Carsten, 42929 Wermelskirchen (DE); Stadler, Peter, 57482 Wenden (DE); Stier, Martin, 59368 Werne (DE)
(74) Vertreter: Delphi France SAS

(56) Entgegenhaltungen:
- DE-A1- 10 235 208
- US-A- 5 097 101
- US-A1- 2002 030 276
- US-A1- 2004 227 256
- US-A1- 2005 237 365
- US-B1- 6 417 997
- US-B1- 6 881 611

## Beschreibung

Die Erfindung betrifft ein elektronisches Bauteil mit einem Halbleiterelement und zumindest einem an einer Seite des Halbleiterelements befestigten Kontaktelement.

Herkömmliche elektronische Bauteile werden häufig durch Drähte (wire bonding) oder mittels der Flip-Chip-Technologie, d. h. durch eine direkte Kontaktierung der aktiven Kontaktierungsseite des Halbleiters mit Leiterbahnen eines Substrats ohne Verwendung von Anschlussdrähten, kontaktiert. Bei letzterer Methode ist das Substrat mit Lotkugeln (bumps) versehen, die bei Erhitzung aufschmelzen und eine elektrisch leitende und mechanische Verbindung zwischen Kontaktstellen des Halbleiterelements und den Kontakten des Substrats herstellen. Allerdings weisen sowohl das wire bonding als auch die Kontaktierung mit dem Flip-Chip-Verfahren einige Nachteile auf.

Einerseits beansprucht eine Kontaktierung durch wire bonding erheblichen Bauraum, da die Drähte in einem Bogen von der Oberseite des Halbleiters bis auf das Substrat geführt werden müssen. Andererseits können die Anschlussdrähte auch nicht beliebig geführt werden, da sich die Drähte auch bei Vibrationen des Bauteils nicht berühren dürfen. Dadurch wird die Herstellung komplex verschalteter Baugruppen erschwert. Dieses Verfahren ist zudem relativ kostenintensiv.

Demgegenüber ist die Flip-Chip-Montage zwar kostengünstiger. Allerdings müssen die eingangs beschriebenen Lotkugeln auf dem Substrat und/oder dem Halbleiterbauteil bereitgestellt werden, was einer Reihe von vorbereitenden Produktionsschritten bedarf.

Die US 6,417,997 B1 beschreibt ein elektronisches Bauteil mit einem Halbleiterelement und zumindest einem an einer Seite des Halbleiterelements befestigten Kontaktelement gemäß dem Oberbegriff des Anspruchs 1. Zudem beschreibt die genannte Druckschrift, Kontakthöcker in dem Kontaktelement durch Prägen zu erzeugen.

Ein elektronisches Bauteil gemäß dem Oberbegriff des Anspruchs 1 geht auch aus der US 2002/0030276 A1 hervor.

Die US 5,097,101 A befasst sich mit einem flexiblen Substrat mit zumindest einer Leiterbahn, das zumindest einen Höcker aufweist, der eine lokale Erhebung bezüglich einer Ebene des Substrats bildet und der derart positioniert und dimensioniert ist, dass zumindest ein Abschnitt der Leiterbahn des Substrats auf dem Höcker verläuft. Weiterhin offenbart die genannte Druckschrift ein Verfahren zur Herstellung des Höckers in dem Substrat durch Prägen.

Die DE 102 35 208 A1 beschreibt ein Kontaktelement, bestehend aus einem Substrat, das mit mindestens einem lokal begrenzten Vorsprung versehen ist, und einer elektrisch leitenden Beschichtung, die sich auf dem Substrat und auch auf dem Vorsprung befindet. Die genannte Druckschrift beschreibt darüber hinaus ein Verfahren zur Herstellung eines solchen Kontaktelements mittels eines Prägeprozesses.

Die US 2005/0237365 A1 beschreibt einen Aktuator mit zumindest einem an einer Seite des Aktuators befestigten Kontaktelement, wobei das Kontaktelement eine flexible Leiterfolie mit wenigstens einer Leiterbahn umfasst. Die Leiterfolie weist einen Höcker auf, der eine lokale Erhebung bezüglich einer Ebene der Leiterfolie bildet und der derart positioniert und dimensioniert ist, dass zumindest ein Abschnitt der Leiterbahn der Leiterfolie auf dem Höcker verläuft, wobei der Leiterbahnabschnitt in elektrischem Kontakt mit wenigstens einer Kontaktstelle des Aktuators steht. Zudem beschreibt die genannte Druckschrift, Kontakthöcker in dem Kontaktelement durch Prägen zu erzeugen.

Die US 6,881,611 B1 offenbart ein elektronisches Bauteil mit einem Halbleiterelement und zumindest einem an einer Seite des Halbleiterelements befestigten Kontaktelement, wobei das Kontaktelement eine flexible Leiterfolie mit wenigstens einer Leiterbahn umfasst. Die Leiterfolie weist einen Höcker auf, der eine lokale Erhebung bezüglich einer Ebene der Leiterfolie bildet und der derart positioniert und dimensioniert ist, dass zumindest ein Abschnitt der Leiterbahn der Leiterfolie auf dem Höcker verläuft.

Die US 2004/0227256 A1 betrifft ebenfalls ein elektronisches Bauteil mit einem Halbleiterelement und zumindest einem an einer Seite des Halbleiterelements befestigten Kontaktelement, wobei das Kontaktelement eine flexible Leiterfolie mit wenigstens einer Leiterbahn umfasst. Die Leiterfolie weist einen Höcker auf, der eine lokale Erhebung bezüglich einer Ebene der Leiterfolie bildet und der derart positioniert und dimensioniert ist, dass zumindest ein Abschnitt der Leiterbahn der Leiterfolie auf dem Höcker verläuft, wobei der Leiterbahnabschnitt in elektrischem Kontakt mit wenigstens einer Kontaktstelle des Halbleiterelements steht.

Der Erfindung liegt daher die Aufgabe zugrunde, ein kompaktes elektronisches Bauteil mit einem Kontaktelement zu schaffen, welches kostengünstig herzustellen und gleichzeitig flexibel einsetzbar ist, so dass es in einer Vielzahl von verschiedenen Schaltungen verwendet werden kann.

Die Lösung dieser Aufgabe erfolgt durch die Merkmale der unabhängigen Ansprüche.

Das erfindungsgemäße elektronische Bauteil weist ein Halbleiterelement und zumindest ein an einer Seite des Halbleiterelements befestigtes Kontaktelement auf. Das Kontaktelement umfasst eine flexible Leiterfolie mit wenigstens einer Leiterbahn. Die Leiterfolie weist bei im Wesentlichen gleich bleibender Leiterfoliendicke zumindest einen Höcker auf, der eine lokale Erhebung bezüglich einer Leiterfolienebene bildet. Der Höcker ist derart positioniert und dimensioniert, dass zumindest ein Abschnitt der Leiterbahn der Leiterfolie auf dem Höcker verläuft. Der Leiterbahnabschnitt steht in elektrischem Kontakt mit wenigstens einer Kontaktstelle des Halbleiterelements.

Mit anderen Worten ist das Halbleiterelement mit einer flexiblen Kontaktfolie verbunden, die Höcker oder Buckel aufweist, die sich aus einer Leiterfolienebene erheben. Diese Erhebungen sind allerdings keine lokalen Verdickungen der Leiterfolie. Die Leiterfolie weist in dem Bereich des Höckers im Wesentlichen die gleiche Dicke auf, wie in den übrigen Bereichen.

Um eine zuverlässige Kontaktierung zu ermöglichen, verläuft zumindest ein Abschnitt der Leiterbahn der Leiterfolie auf dem Höcker. Insbesondere kann der Leiterbahnabschnitt auf dem Höcker enden. Mit anderen Worten liegt der Leiterbahnabschnitt auf dem Höcker in einer Ebene über der Leiterfolienebene - ragt somit aus ihr heraus - und kann auf einfache Weise mit der Kontaktstelle des Halbleiters kontaktiert werden.

Ein entsprechender Höcker kann auf einfache Weise in der flexiblen Leiterfolie ausgeformt werden. Die Kontaktierung der Leiterfolie mit dem Halbleiterelement stellt ebenfalls kein Problem dar, da die räumliche Anordnung und Ausdehnung des Höckers an die Anordnung und Ausdehnung der Kontaktstelle des Halbleiterelements angepasst ist.

Die Leiterfolie weist mehrere Höcker und Leiterbahnen auf, so dass auch komplexe Verschaltungen eines mehrere Kontaktstellen umfassenden Halbleiterelements realisiert werden können. Zudem erfolgt die Kontaktierung der verschiedenen Höcker mit den Kontaktstellen des Halbleiterelements - im Gegensatz zu einer Kontaktierung mittels Drähten - in einem Arbeitsschritt. Die Verwendung einer flexiblen Leiterfolie als Kontaktelement bietet außerdem die Möglichkeit, das Halbleiterelement auf variable Weise mit anderen Bauteilen zu verbinden, da die flexible Leiterfolie - anders als starre Leiterplatten - in einem gewissen Rahmen Relativbewegungen zwischen verschiedenen Komponenten einer elektronischen Schaltung zulässt, in die das erfindungsgemäße elektronische Bauteil integriert ist.

Vorteilhafte Ausführungsformen der Erfindung sind in den Unteransprüchen, der Beschreibung und den Zeichnungen angegeben.

Um größere Relativbewegungen zwischen verschiedenen Komponenten einer Schaltung zu ermöglichen, kann das Kontaktelement zusätzlich zu dem zumindest einen Höcker in seinem Verlauf zumindest abschnittsweise mehrere Abwinklungen und/oder Krümmungen aufweisen. Diese Abwinklungen/Krümmungen können insbesondere im Verlauf des Kontaktelements vorgesehen sein, der sich außerhalb eines Kontaktierungsbereichs der Leiterfolie befindet. Der Kontaktierungsbereich ist dabei der Bereich der Leiterfolie, der die Höcker aufweist und daher zur Kontaktierung und Befestigung der Leiterfolie an dem Halbleiterelement vorgesehen ist. Grundsätzlich können derartige Abwinklungen/Krümmungen auch bei elektronischen Bauteilen vorgesehen sein, die mittels herkömmlicher Kontaktierungsverfahren mit einer Leiterfolie ohne Höcker verbunden sind.

Durch die Abwinklungen/Krümmungen können beispielsweise Effekte von einer thermischen Ausdehnung der Komponenten einer Schaltung ausgeglichen werden, was bei der Verwendung von im Wesentlichen starren Leiterplatten zumeist nicht - oder nur mit großem Aufwand - möglich ist. Die Abwinklungen und/oder Krümmungen können beispielsweise einen wellenartigen bzw. ziehharmonikaartigen Abschnitt im Verlauf der Leiterfolie bilden.

Die Höcker können verschiedenartig ausgebildet sein und beispielsweise einen im Wesentlichen kuppelförmigen, U-förmigen, rechteckigen oder dreieckigen Querschnitt in einer Ebene senkrecht zu der Leiterfolienebene aufweisen. Die Dimensionierung der Höcker in einer Leiterfolienebene, d.h. die jeweils von ihnen eingenommene Fläche, kann ebenfalls den speziellen Bedürfnissen angepasst werden. Beispielhaft seien an dieser Stelle quadratische, rechteckige, kreisförmige und ovale Höcker genannt, wobei allerdings auch komplexere Formen realisiert werden können. Die Leiterfolie ist mit mehreren Höcker versehen, die unterschiedliche Querschnitte aufweisen und/oder die unterschiedlich dimensioniert sind. Mit anderen Worten können verschiedene Arten von Höckern kombiniert werden, um eine optimale Anbindung des Halbleiterelements an die Leiterbahnen der Leiterfolie zu gewährleisten.

In vielen Fällen ist es vorteilhaft, wenn die Höcker dabei eine im Wesentlichen gleiche Höhe - wobei unter "Höhe" der Abstand zwischen einem Scheitelpunkt des Höckers und der Leiterfolienebene zu verstehen ist - aufweisen. Bei einer entsprechenden Ausgestaltung der Topographie der Kontaktseite des Halbleiterelements können die Höcker allerdings auch unterschiedliche Höhen oder Höhenprofile aufweisen.

Gemäß einer Ausführungsform des erfindungsgemäßen elektronischen Bauteils ist eine von der den Höcker aufweisenden Leiterfolie abgewandte Seite des Halbleiterelements mit einem Substrat oder einem Kühlelement verbunden. Dadurch kann das Halbleiterelement zuverlässig fixiert und/oder mit einer effizienten Wärmesenke versehen werden.

Der auf dem Höcker verlaufende Leiterbahnabschnitt kann mit der Kontaktstelle des Halbleiterelements mittels eines leitfähigen Klebstoffs elektrisch leitend verbunden sein. Dabei können isotrop oder anisotrop leitfähige Klebstoffe Anwendung finden. Es kann auch vorgesehen sein, die Kontaktstelle des Halbleiterelements mit dem auf dem Höcker verlaufenden Leiterbahnabschnitt zu verlöten. Die Wahl der Verbindungsart hängt unter anderem von der Größe der Kontaktstellen und den geforderten Eigenschaften des elektronischen Bauteils ab.

Der auf dem Höcker verlaufende Leiterbahnabschnitt umfasst eine Kontaktfläche, welche in der Leiterfolienebene in einer Längserstreckungsrichtung der Leiterbahn breiter ist als die Leiterbahn, und welche mit der Kontaktstelle des Halbleiterelements verbindbar ist. Dies vereinfacht das Kontaktieren der Leiterbahn mit der Kontaktstelle des Halbleiterelements. Insbesondere mündet die Leiterbahn auf dem Höcker in die Kontaktfläche und endet dort.

Bei einer Weiterbildung des erfindungsgemäßen elektronischen Bauteils beträgt die Dicke der Leiterfolie etwa 0,4 bis 2 mm. Eine derartige Leiterfolie ermöglicht ein einfaches Ausformen der Höcker und/oder Abwinklungen und/oder Krümmungen und weist eine ausreichend gute Flexibilität auf, um das elektronische Bauteil auf vielfältige Weise einsetzen zu können.

Die Erfindung betrifft weiterhin eine elektronische Schaltung, die zumindest zwei elektronische Bauteile gemäß einer der vorstehend beschriebenen Ausführungsformen umfasst, wobei die elektronischen Bauteile ein gemeinsames Kontaktelement aufweisen. Mit anderen Worten sind die elektronischen Bauteile der elektronischen Schaltung mit ein und derselben Leiterfolie verbunden.

Weiterhin umfasst die Erfindung ein Verfahren zur Herstellung eines elektronischen Bauteils.

In einem ersten Schritt werden ein Halbleiterelement und eine flexible, im Wesentlichen planare Leiterfolie mit wenigstens einer Leiterbahn bereitgestellt. Die Leiterfolie wird in einen Bereich zwischen Gesenkhälften einer Maschine zum Prägen der Leiterfolie eingebracht. Anschließend werden die Gesenkhälften geschlossen und die Leiterfolie wird mit einem erhöhten Druck beaufschlagt, wodurch die Leiterfolie verformt wird. Anschließend wird der Druck wieder abgebaut. Die Gesenkhälften werden geöffnet und die geprägte Leiterfolie wird entnommen.

Das Halbleiterelement wird derart mit der Leiterfolie kontaktiert, dass zumindest eine Kontaktstelle des Halbleiterelements mit der Leiterbahn in Kontakt gebracht wird, die zumindest abschnittsweise auf zumindest einem Höcker verläuft, der durch die Gesenkhälften in die Leiterfolie geprägt wurde.

Die Gesenkhälften werden vor dem Einbringen der Leiterfolie auf eine Arbeitstemperatur vorgeheizt. Während einer ersten Phase der Druckbeaufschlagung entspricht die Temperatur der Gesenkhälften im Wesentlichen der Arbeitstemperatur. Während einer zweiten Phase der Druckbeaufschlagung werden die Gesenkhälften abgekühlt. Die erste Phase dient somit der thermoplastischen Verformung der Leiterfolie. Durch das Abkühlen - weiterhin unter Druckbeaufschlagung - wird eine dauerhafte und qualitativ hochwertige Ausformung der gewünschten Höcker und/oder Abwicklungen und/oder Krümmungen erzeugt.

Der Druck ist während der ersten und der zweiten Phase der Druckbeaufschlagung im Wesentlichen gleich und konstant, d. h. der angelegte Druck ändert sich während der Druckbeaufschlagung im Wesentlichen nicht.

Die Arbeitstemperatur liegt in einem Bereich von etwa 50 bis 200°C. Dieser Temperaturbereich hat sich als besonders geeignet für das Verformen der Leiterfolie erwiesen.

Die erste Phase der Druckbeaufschlagung umfasst eine Dauer von etwa 1 bis 10 Sekunden. Die zweite Phase der Druckbeaufschlagung umfasst eine Dauer von etwa 1 bis 5 Sekunden.

Gemäß einer weiteren Ausführungsform des erfindungsgemäßen Verfahrens werden das Halbleiterelement und die Leiterfolie mit Hilfe eines leitfähigen Klebstoffs oder durch Löten elektrisch leitend miteinander verbunden.

Die Erfindung wird im Folgenden rein beispielhaft anhand vorteilhafter Ausführungsformen und unter Bezugnahme auf die Zeichnungen beschrieben. Es zeigen:
- Fig. 1: einen Querschnitt durch eine Ausführungsform des erfindungsgemäßen elektronischen Bauteils,
- Fig. 2: eine Ansicht der Kontaktseite des elektronischen Bauteils von Fig. 1,
- Fig. 3: eine Ausführungsform eines Kontaktelements eines erfindungsgemäßen elektronischen Bauteils,
- Fig. 4: beispielhafte Querschnitte eines Höckers.

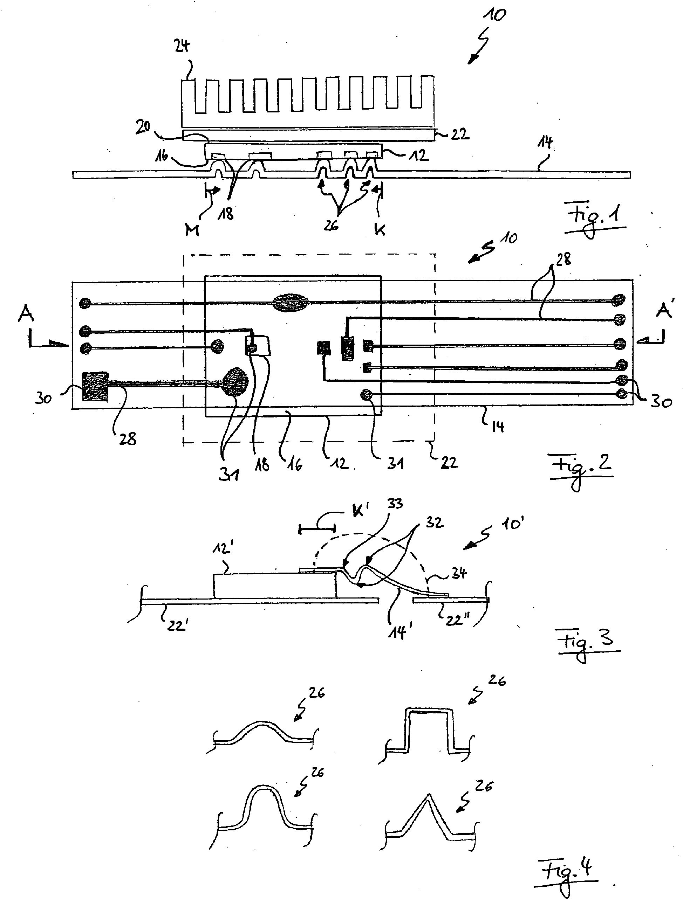

Fig. 1 zeigt ein elektronisches Bauteil 10, welches ein Halbleiterelement 12 und eine Leiterfolie 14 aufweist, die das Kontaktelement des elektronischen Bauteils bildet. Die Leiterfolie 14 kann auf einer Reihe von unterschiedlichen Kunststoffen basieren, beispielsweise auf PEN, PET, PETF, GHE, PI oder PEEK.

Das Halbleiterelement 12 weist eine Kontaktseite 16 auf, an der eine Mehrzahl von Kontaktstellen 18 angeordnet ist, die zur Kontaktierung des Halbleiterelements 12 - welches insbesondere ein ungehäustes Halbleiterbauteil (die) sein kann - dient. Die der Kontaktseite 16 gegenüberliegende Seite des Halbleiterelements 12 bildet eine Montageseite 20. In der dargestellten Ausführungsform ist an der Montageseite 20 ein Substrat 22 befestigt, welches wiederum mit einem Kühlelement 24 verbunden ist. Die Montageseite 20 dient somit der Montage des Kühlelements 24 und ermöglicht eine effiziente Abfuhr der bei Betrieb des Halbleiterelements 12 entstehenden Abwärme. In bestimmten Fällen kann die hier als Montageseite 20 bezeichnete Seite des Halbleiterelements 12 ebenfalls Kontaktstellen 18 aufweisen, die zusätzliche Kontaktierungsmöglichkeiten bereitstellen.

Die Kontaktstellen 18 der Kontaktseite 16 sind mit Höckern 26 verbunden, die lokal begrenzte Erhebungen im Verlauf der Leiterfolie 14 bilden. Es ist zu erkennen, dass die Höcker 26 integrale Bestandteile der Leiterfolie 14 sind. Sie werden nicht durch zusätzlich aufgebrachtes Material oder verdickte Bereiche im Verlauf der Leiterfolie 12 gebildet.

Der mit den Höckern 26 versehene Bereich der Leiterfolie wird als Kontaktierungsbereich K bezeichnet, und ist in Fig. 1 durch zwei vertikale Striche mit jeweils einem Pfeil markiert. Der Kontaktierungsbereich K entspricht im Wesentlichen der vertikalen Projektion des Halbleiterelements 12 auf die Leiterfolie 14.

Auf den Höckern 26 verlaufen und/oder enden Abschnitte von Leiterbahnen 28, wie nachstehend anhand von Fig. 2 erläutert wird. Die Verbindung der Leiterfolie 14 mit dem Halbleiterelement 12 und der Leiterbahnabschnitte auf den Höckern 26 mit den Kontaktstellen 18 kann auf verschiedene Weise hergestellt werden. Das Kontaktieren kann insbesondere durch isotrop oder anisotrop leitfähigen Klebstoff (nicht gezeigt) und/oder Löten (Lötstellen nicht gezeigt) erfolgen.

Fig. 2 zeigt eine Ansicht der Kontaktseite 16 des Halbleiterelements 12, wobei die Leiterfolie 14 transparent dargestellt ist, um weitere Merkmale des erfindungsgemäßen Bauteils 10 beschreiben zu können. Der Kontaktierungsbereich K deckt sich in dieser Ansicht im Wesentlichen mit dem Umriss des Halbleiterelements 12. Die Lage des in Fig. 1 gezeigten Schnitts durch das elektronische Bauteil 10 ist durch die Schnittlinie AA' angegeben.

Die Leiterfolie 14 umfasst eine Mehrzahl von Leiterbahnen 28. An dem linken und dem rechten Ende der Leiterfolie 14 enden die Leiterbahnen 28 in Kontaktflächen 30, die das Kontaktieren der Leiterfolie 14 mit weiteren Komponenten einer Schaltung (nicht gezeigt) ermöglichen. Die Kontaktflächen 30 können unterschiedliche Formen aufweisen (z. B. quadratisch, rechteckig, kreisförmig oder oval) und von beliebiger Größe sein. Zur Verbindung der Leiterbahnen 28 mit den Kontaktstellen 18 des Halbleiterelements 12 sind Kontaktflächen 31 vorgesehenen, die ebenfalls unterschiedliche Formen und Größen aufweisen können. Die Kontaktflächen 31 liegen zumindest teilweise auf den Höckern 26.

Bei der dargestellten Ausführungsform sind die Kontaktflächen 31 größer als die Kontaktstellen 18 des Halbleiterelements 12, so dass die Kontaktstellen 18 in dieser Ansicht von den Kontaktflächen 31 verdeckt werden. Eine Ausnahme bildet eine Verbindung im mittleren Bereich der Kontaktseite 16 des Halbleiterelements 12. In diesem Fall ist die Kontaktstelle 18 größer als die entsprechende Kontaktfläche 31.

Das Vorsehen der im Gegensatz zu den Leiterbahnen 28 verbreiterten/vergrößerten Kontaktflächen 31 erleichtert das Positionieren des Halbleiterelements 12 bezüglich der Höcker 26 der Leiterfolie 12. Außerdem können dadurch großflächigere und somit zuverlässigere elektrische Kontakte hergestellt werden.

Wie aus Fig. 2 ersichtlich, können die Leiterbahnen 28 auf der Leiterfolie 14 beliebig angeordnet werden, so dass auch komplexe Verschaltungen des Halbleiterelements 12 möglich sind. Die Höcker 26 können beispielsweise während eines einzigen Arbeitsgangs in die Leiterfolie 14 geprägt werden, wodurch die Herstellungskosten des elektronischen Bauteils 10 deutlich reduziert werden. Auch die Kontaktierung der Kontaktstellen 18 des Halbleiterelements 12 mit den Leiterbahnen 28 erfolgt in einem einzigen Schritt.

Fig. 3 zeigt ein weiteres elektronisches Bauteil 10', das ebenfalls über ein Halbleiterelement 12' verfügt. Das Halbleiterelement 12' ist auf einem Substrat 22' befestigt, wobei es sich bei dem Substrat 22' auch um eine flexible Leiterfolie handeln kann. An einer dem Substrat 22' abgewandten Seite des Halbleiterelements 12' ist eine Leiterfolie 14' mit darauf angeordneten Leiterbahnen (nicht gezeigt) angebracht. Ein Kontaktierungsbereich K' überdeckt - im Gegensatz zu dem Kontaktierungsbereich K des vorstehend beschriebenen Beispiels - nicht die gesamte Fläche einer Seite des Halbleiterelements 12'.

Die Leiterfolie 14' dient zur Kontaktierung des Halbleiterelements 12' mit einem Substrat 22", das nicht einstückig mit dem Substrat 22' ausgeführt ist.

Die Leiterfolie 14' weist in ihrem Verlauf Krümmungen 32 und eine Abwinklung 33 auf, die durch thermoplastisches Verformen der Leiterfolie 14' erzeugt wurden. Der Verlauf der Leiterfolie 14 'weist somit einen wellenförmigen Abschnitt auf, durch den Relativbewegungen zwischen den Substraten 22', 22" kompensiert werden können. Das Halbleiterelement 12' kann an seiner der Leiterfolie 14' abgewandten Seite ebenfalls Kontaktstellen (nicht gezeigt) aufweisen, die mit Leiterbahnen (nicht gezeigt) des Substrats 22' auf herkömmliche Weise verbunden sind. Die Verbindung von Kontaktstellen (nicht gezeigt) an der Oberseite des Halbleiterelements 12' mit der Leiterfolie 14' kann auf verschiedene Arten, insbesondere mittels der vorstehend beschriebenen Höcker 26, realisiert werden.

Fig. 2 zeigt darüber hinaus einen der Vorteile, der sich aus der Verwendung einer flexiblen Leiterfolie 14' an Stelle einer konventionellen Bonddrahtverbindung 34 ergibt. Der Bonddraht 34 ist durch eine gestrichelte Linie dargestellt. Da ein halbleiterelementseitiges Ende des Bonddrahts 34 senkrecht von oben auf das Halbleiterelement 12' aufgebracht wird und der Bonddraht 34 aufgrund seiner Materialeigenschaften nicht beliebig stark krümmbar ist, weisen vergleichbare elektronische Bauteile mit einer Bonddrahtverbindung 34 eine minimale Bauhöhe auf, die deutlich größer ist als die des in Fig. 3 dargestellten elektronischen Bauteils 10'. Das elektronische Bauteil 10' weist somit eine kompaktere Bauweise auf, als mittels wire bonding kontaktierte Bauteile.

Fig. 4 zeigt beispielhaft verschiedene Querschnitte senkrecht zur Leiterfolienebene durch einen Höcker 26. Der Höcker 26 kann beispielsweise einen kuppelförmigen (links oben), U-förmigen (links unten), rechteckigen (rechts oben) oder kegelförmigen/dreieckigen (rechts unten) Querschnitt aufweisen.

### Bezugszeichenliste

- 10, 10': elektronisches Bauteil
- 12, 12': Halbleiterelement
- 14, 14': Leiterfolie
- 16: Kontaktseite
- 18: Kontaktstelle
- 20: Montageseite
- 22, 22', 22": Substrat
- 24: Kühlelement
- 26: Höcker
- 28: Leiterbahn
- 30,31: Kontaktfläche
- 32: Krümmung
- 33: Abwinklung
- 34: Bonddraht

- AA': Schnittlinie
- K, K': Kontaktierungsbereich

## Patentansprüche

1. Elektronisches Bauteil mit einem Halbleiterelement (12, 12') und zumindest einem an einer Seite des Halbleiterelements (12, 12') befestigten Kontaktelement, wobei das Kontaktelement eine flexible Leiterfolie (14, 14') mit wenigstens einer Leiterbahn (28) umfasst, und wobei die Leiterfolie (14, 14') bei gleich bleibender Leiterfoliendicke zumindest einen Höcker (26) aufweist, der eine lokale Erhebung bezüglich einer Leiterfolienebene bildet und der derart positioniert und dimensioniert ist, dass zumindest ein Abschnitt der Leiterbahn (28) der Leiterfolie (14, 14') auf dem Höcker (26) verläuft, wobei der Leiterbahnabschnitt in elektrischem Kontakt mit wenigstens einer Kontaktstelle (18) des Halbleiterelements (12, 12') steht,
**dadurch gekennzeichnet, dass**
die Leiterfolie (14, 14') mehrere Höcker (26) aufweist, die unterschiedliche Querschnitte aufweisen und/oder unterschiedlich dimensioniert sind, und
dass der auf dem Höcker (26) verlaufende Leiterbahnabschnitt eine Kontaktfläche (31) umfasst, welche in der Leiterfolienebene in einer Längserstreckungsrichtung der Leiterbahn (28) breiter ist als die Leiterbahn (28), und welche mit der Kontaktstelle (18) des Halbleiterelements (12, 12') verbindbar ist.

2. Elektronisches Bauteil nach Anspruch 1,
**dadurch gekennzeichnet, dass**
die Kontaktfläche (31) des auf dem Höcker (26) verlaufenden Leiterbahnabschnitts größer ist als die entsprechende Kontaktstelle (18) des Halbleiterelements (12, 12').

3. Elektronisches Bauteil nach Anspruch 1 oder 2,
**dadurch gekennzeichnet, dass**
das Kontaktelement zusätzlich zu dem Höcker (26) in seinem Verlauf zumindest abschnittsweise mehrere Abwinklungen (33) und/oder Krümmungen (32) aufweist.

4. Elektronisches Bauteil nach einem der vorstehenden Ansprüche,
**dadurch gekennzeichnet, dass**
eine von der den Höcker (26) aufweisenden Leiterfolie (14, 14') abgewandte Seite (20) des Halbleiterelements (12, 12') mit einem Substrat (22, 22') oder einem Kühlelement (24) verbunden ist.

5. Elektronisches Bauteil nach einem der vorstehenden Ansprüche,
**dadurch gekennzeichnet, dass**
der Höcker (26) in einer Ebene senkrecht zu der Leiterfolienebene einen kuppelförmigen, U-förmigen, rechteckigen oder dreieckigen Querschnitt aufweist.

6. Elektronisches Bauteil nach einem der vorstehenden Ansprüche,
**dadurch gekennzeichnet, dass**
die Kontaktstelle (18) des Halbleiterelements (12, 12') mittels eines leitfähigen Klebstoffs mit dem auf dem Höcker (26) verlaufenden Leiterbahnabschnitt elektrisch leitend verbunden ist.

7. Elektronisches Bauteil nach einem der Ansprüche 1 bis 5,
**dadurch gekennzeichnet, dass**
die Kontaktstelle des Halbleiterelements (12, 12') mit dem auf dem Höcker (26) verlaufenden Leiterbahnabschnitt elektrisch leitend verlötet ist.

8. Elektronisches Bauteil nach einem der vorstehenden Ansprüche,
**dadurch gekennzeichnet, dass**
die Leiterfolie (14, 14') eine Dicke von etwa 0,4 bis 2 mm aufweist.

9. Elektronische Schaltung, die zumindest zwei elektronische Bauteile nach einem der vorstehenden Ansprüche umfasst, wobei die elektronischen Bauteile ein gemeinsames Kontaktelement aufweisen.

10. Verfahren zur Herstellung eines elektronischen Bauteils nach Anspruch 1 mit den Schritten:
Bereitstellen eines Halbleiterelements (12, 12') und einer flexiblen, planaren Leiterfolie (14, 14') mit wenigstens einer Leiterbahn (28);
Einbringen der Leiterfolie (14, 14') in einen Bereich zwischen Gesenkhälften einer Maschine zum Prägen der Leiterfolie (14, 14');
Vorheizen der Gesenkhälften auf eine Arbeitstemperatur, wobei die Arbeitstemperatur in einem Bereich von etwa 50 bis 200°C liegt;
Schließen der Gesenkhälften und Beaufschlagung der Leiterfolie (14, 14') mit einem erhöhten Druck;
wobei während einer ersten Phase der Druckbeaufschlagung die Temperatur der Gesenkhälften der Arbeitstemperatur entspricht; und
wobei die Gesenkhälften während einer zweiten Phase der Druckbeaufschlagung abgekühlt werden;
wobei der Druck während der ersten und der zweiten Phase der Druckbeaufschlagung gleich und konstant ist;
wobei die erste Phase der Druckbeaufschlagung eine Dauer von etwa 1 bis 10 Sekunden umfasst, und wobei die zweite Phase der Druckbeaufschlagung eine Dauer von etwa 1 bis 5 Sekunden umfasst;
Abbau des Drucks, Öffnen der Gesenkhälften und Entnahme der geprägten Leiterfolie (14, 14');
Kontaktieren des Halbleiterelements (12, 12') derart mit der Leiterfolie (14, 14'), dass zumindest eine Kontaktstelle (18) des Halbleiterelements (12, 12') mit der Leiterbahn (28) in Kontakt gebracht wird, die zumindest abschnittsweise auf zumindest einem Höcker (26) verläuft, der durch die Gesenkhälften in die Leiterfolie (14, 14') geprägt wurde.

11. Verfahren nach Anspruch 10,
**dadurch gekennzeichnet, dass**
das Halbleiterelement (12, 12') und die Leiterfolie (14, 14') mit Hilfe eines leitfähigen Klebstoffs oder durch Löten elektrisch leitend miteinander verbunden werden.

12. Verfahren nach Anspruch 10 oder 11,
**dadurch gekennzeichnet, dass**
zusätzlich zu dem zumindest einen Höcker (26) mehrere Abwinklungen (33) und/oder Krümmungen (32) in die Leiterfolie (14, 14') geprägt werden.

## Claims

1. An electronic component comprising a semiconductor element (12, 12') and at least one contact element attached to a side of the semiconductor element (12, 12'), wherein the contact element includes a flexible conductor foil (14, 14') with at least one conductive path (28), and wherein the conductor foil (14, 14'), at constant conductor foil thickness, has at least one bump (26) forming a local elevation with respect to a conductor foil plane and which is positioned and dimensioned such that at least a section of the conductive path (28) of the conductor foil (14, 14') extends on the bump (26), wherein the conductive path section is in electrical contact with at least one contact point (18) of the semiconductor element (12, 12'),
**characterized in that**
the conductor foil (14, 14') comprises a plurality of bumps (26) having different cross-sections and/or different dimensions, and
the conductive path section extending on the bump (26) includes a contact area (31) which is wider than the conductive path (28) in the conductor foil plane in a longitudinal direction of the conductive path (28) and which is connectable to the contact point (18) of the semiconductor element (12, 12').

2. Electronic component according to claim 1,
**characterized in that**
the contact area (31) of the conductive path section extending on the bump (26) is larger than the corresponding contact point (18) of the semiconductor element (12, 12').

3. Electronic component according to claim 1 or 2,
**characterized in that**
the contact element comprises in its course, in addition to the bump (26), at least partially a plurality of angled portions (33) and/or bends (32).

4. Electronic component according to one of the preceding claims,
**characterized in that**
a side (20) of the semiconductor element (12, 12') facing away from the conductor foil (14, 14') having the bump (26) is connected to a substrate (22, 22') or a cooling element (24).

5. Electronic component according to one of the preceding claims,
**characterized in that**
the bump (26) has a dome-shaped, U-shaped, rectangular or triangular cross-section in a plane perpendicular to the conductor foil plane.

6. Electronic component according to one of the preceding claims,
**characterized in that**
the contact point (18) of the semiconductor element (12, 12') is connected in an electrically conductive way by means of a conductive adhesive to the conductive path section extending on the bump (26).

7. Electronic component according to one of claims 1 to 5,
**characterized in that**
the contact point of the semiconductor element (12, 12') is soldered in an electrically conductive way to the conductive path section extending on the bump (26).

8. Electronic component according to one of the preceding claims,
**characterized in that**
the conductor foil (14, 14') has a thickness of about 0.4 to 2 mm.

9. Electronic circuit comprising at least two electronic components according to one of the preceding claims, wherein the electronic components have a common contact element.

10. A method for manufacturing an electronic component according to claim 1, comprising the steps of:
providing a semiconductor element (12, 12') and a flexible planar conductor foil (14, 14') with at least one conductive path (28);
inserting the conductor foil (14, 14') in an area between die halves of a machine for embossing the conductor foil (14, 14');
pre-heating the die halves to an operating temperature, the operating temperature in a range of about 50° to 200°C;
closing the die halves and actuating on the conductor foil (14, 14') at an increased pressure;
wherein the temperature of the die halves corresponds to the operating temperature during a first phase of the pressure actuation; and
the die halves are cooled during a second phase of the pressure actuation; wherein the pressure is equal and constant during the first and second phase of the pressure actuation;
wherein the first phase of the pressure actuation has a period of about 1 to 10 seconds and the second phase of the pressure actuation has a period of about 1 to 5 seconds;
reducing the pressure, opening the die halves and removing the embossed conductor foil (14, 14');
contacting the semiconductor element (12, 12') with the conductor foil (14, 14') such that at least one contact point (18) of the semiconductor element (12, 12') is in contact with the conductive path (28), extending at least in sections on at least one bump (26) which was embossed in the conductor foil (14, 14') by the die halves.

11. Method according to claim 10,
**characterized in that**
the semiconductor element (12, 12') and the conductor foil (14, 14') are connected with each other in an electrically conductive way by means of a conductive adhesive or by soldering.

12. Method according to claim 10 or 11,
**characterized in that**
in addition to the at least one bump (26) a plurality of angled portions (33) and/or bends (32) are embossed in the conductor foil (14, 14').

## Revendications

1. Composant électronique comprenant un élément semi-conducteur (12, 12') et au moins un élément de contact fixé sur un côté de l'élément semi-conducteur (12, 12'), dans lequel l'élément de contact inclut une feuille conductrice flexible (14, 14') avec au moins une piste conductrice (28), et dans lequel la feuille conductrice (14, 14') comporte, pour une épaisseur de feuille qui reste constante, au moins une bosse (26) qui forme une surélévation locale par rapport à un plan de la feuille conductrice, et qui est positionnée et dimensionné de telle façon qu'au moins un tronçon de la piste conductrice (28) de la feuille conductrice (14, 14') s'étend sur la bosse (26), et le tronçon de piste conductrice est en contact électrique avec au moins un emplacement de contact (18) de l'élément semi-conducteur (12, 12'),
**caractérisé en ce que**
la feuille conductrice (14, 14') comporte plusieurs bosses (26) qui présentent des sections différentes et/ou qui sont de dimensions différentes, et
**en ce que** le tronçon de piste conductrice qui s'étend sur la bosse (26) inclut une surface de contact (31) qui, dans un plan de la feuille conductrice dans une direction d'extension longitudinale de la piste conductrice (28), est plus large que la piste conductrice (28), et qui est susceptible d'être connectée avec l'emplacement de contact (18) de l'élément semi-conducteur (12, 12').

2. Composant électronique selon la revendication 1,
**caractérisé en ce que** la surface de contact (31) du tronçon de piste conductrice qui s'étend sur la bosse (26) est plus grande que l'emplacement de contact correspondant (18) de l'élément semi-conducteur (12, 12').

3. Composant électronique selon la revendication 1 ou 2,
**caractérisé en ce que** l'élément de contact comporte, en supplément de la bosse (26), dans son tracé et au moins par tronçons plusieurs coudages (33) et/ou plusieurs courbures (32).

4. Composant électronique selon l'une des revendications précédentes,
**caractérisé en ce qu'**un côté (20) de l'élément semi-conducteur (12, 12'), détourné de la feuille conductrice (14, 14') comportant la bosse (26), est relié avec un substrat (22, 22') ou avec un élément de refroidissement (24).

5. Composant électronique selon l'une des revendications précédentes,
**caractérisé en ce que** la bosse (26) présente, dans un plan perpendiculaire au plan de la feuille conductrice, une section transversale en forme de coupole, en forme de U, en forme rectangulaire ou en forme triangulaire.

6. Composant électronique selon l'une des revendications précédentes,
**caractérisé en ce que** l'emplacement de contact (18) de l'élément semi-conducteur (12, 12') est relié de manière électriquement conductrice avec le tronçon de piste conductrice s'étendant sur la bosse (26), au moyen d'une colle conductrice.

7. Composant électronique selon l'une des revendications 1 à 5,
**caractérisé en ce que** l'emplacement de contact de l'élément semi-conducteur (12, 12') est brasé de manière électriquement conductrice avec le tronçon de piste conductrice s'étendant sur la bosse (26).

8. Composant électronique selon l'une des revendications précédentes,
**caractérisé en ce que** la feuille conductrice (14, 14') a une épaisseur d'environ 0,4 à 2 mm.

9. Circuit électronique, qui inclut au moins deux composants électroniques selon l'une des revendications précédentes, dans lequel les composants électroniques présentent un élément de contact commun.

10. Procédé pour la fabrication d'un composant électronique selon la revendication, comprenant les étapes consistant à :
préparer un élément semi-conducteur (12, 12') et une feuille conductrice flexible planaire (14, 14') avec au moins une piste conductrice (28) ;
introduire la feuille conductrice (14, 14') dans une zone entre deux moitiés de matrice d'une machine pour matricer la feuille conductrice (14, 14') ; préchauffer les moitiés de matrice jusqu'à une température de travail, ladite température de travail étant dans une plage d'environ 50 à 200°C ;
fermer les moitiés de matrice et appliquer une pression élevée sur la feuille conductrice (14, 14') ;
dans lequel pendant une première phase de l'application de pression la température des moitiés de matrice correspond à la température de travail ; et
dans lequel les moitiés de matrice sont refroidies pendant une seconde phase de l'application de pression ;
dans lequel la pression pendant la première et la seconde phase de l'application de pression est égale et constante ;
dans lequel la première phase de l'application de pression a une durée d'environ 1 à 10 secondes, et dans lequel la seconde phase de l'application de pression a une durée d'environ 1 à 5 secondes ;
casser la pression, ouvrir les moitiés de matrice, et enlever la feuille conductrice matricée (14, 14') ;
mettre en contact l'élément semi-conducteur (12, 12') avec la feuille conductrice (14, 14') de telle façon qu'au moins un emplacement de contact (18) de l'élément semi-conducteur (12, 12') est amené en contact avec la piste conductrice (28), laquelle s'étend au moins par tronçons sur au moins une bosse (26), qui a été matricée dans la feuille conductrice (14, 14') par les moitiés de matrice.

11. Procédé selon la revendication 10,
**caractérisé en ce que** l'élément semi-conducteur (12, 12') et la feuille conductrice (14, 14') sont reliés l'un à l'autre de manière électriquement conductrice avec l'aide d'une colle conductrice ou par brasage.

12. Procédé selon la revendication 10 ou 11,
**caractérisé en ce que** l'on matrice, additionnellement à ladite au moins une bosse (26), plusieurs coudages (33) et/ou plusieurs courbures (32) dans la feuille conductrice (14, 14').
